(19) Europäisches Patentamt
European Patent Office
Office européen des brevets

(11) **EP 2 408 952 B1**

(12) **EUROPÄISCHE PATENTSCHRIFT**

(45) Veröffentlichungstag und Bekanntmachung des Hinweises auf die Patenterteilung:
**14.08.2019 Patentblatt 2019/33**

(21) Anmeldenummer: **10712028.9**

(22) Anmeldetag: **10.03.2010**

(51) Int Cl.:
*C30B 25/10* (2006.01)    *C30B 25/16* (2006.01)
*C30B 29/40* (2006.01)    *C30B 29/42* (2006.01)
*C23C 16/44* (2006.01)    *C23C 16/46* (2006.01)

(86) Internationale Anmeldenummer:
**PCT/EP2010/053015**

(87) Internationale Veröffentlichungsnummer:
**WO 2010/105947 (23.09.2010 Gazette 2010/38)**

(54) **MOCVD-REAKTOR MIT EINER ÖRTLICH VERSCHIEDEN AN EIN WÄRMEABLEITORGAN ANGEKOPPELTEN DECKENPLATTE**

MOCVD REACTOR HAVING A CEILING PANEL COUPLED LOCALLY DIFFERENTLY TO A HEAT DISSIPATION MEMBER

RÉACTEUR MOCVD À COUVERCLE, COUPLÉ DE MANIÈRE LOCALEMENT DIFFÉRENTE, À UN APPAREIL DISSIPANT LA CHALEUR

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **16.03.2009 DE 102009003624**
**25.02.2010 DE 102010000554**

(43) Veröffentlichungstag der Anmeldung:
**25.01.2012 Patentblatt 2012/04**

(73) Patentinhaber: **Aixtron SE**
**52134 Herzogenrath (DE)**

(72) Erfinder:
• **BRIEN, Daniel**
**52064 Aachen (DE)**
• **PÜSCHE, Roland**
**52072 Aachen (DE)**
• **FRANKEN, Walter**
**52249 Eschweiler (DE)**

(74) Vertreter: **Grundmann, Dirk et al**
**Rieder & Partner mbB**
**Patentanwälte - Rechtsanwalt**
**Corneliusstrasse 45**
**42329 Wuppertal (DE)**

(56) Entgegenhaltungen:
**DE-A1-102007 009 145      JP-A- 2008 195 995**
**US-A1- 2003 005 886      US-A1- 2004 250 773**
**US-B1- 6 206 012**

EP 2 408 952 B1

**Beschreibung**

Die Erfindung betrifft eine Vorrichtung zum Abscheiden mindestens einer, insbesondere kristallinen Schicht auf mindestens einem Substrat, mit einem, den Boden einer Prozesskammer bildenden Suszeptor zur Aufnahme des mindestens einen Substrates, mit einer die Decke der Prozesskammer bildenden Deckenplatte und mit einem Gaseinlassorgan zum Einleiten von sich in der Prozesskammer zufolge Wärmezufuhr in die Schicht bildende Komponenten zerlegenden Prozessgasen und eines Trägergases, wobei unterhalb des Suszeptors eine Vielzahl von nebeneinander liegenden Heizzonen angeordnet sind, mittels derer Wärmeleistungen in den Suszeptor eingeleitet werden, um dessen zur Prozesskammer weisende Oberfläche und das sich in der Prozesskammer befindende Gas aufzuheizen, wobei oberhalb der Deckenplatte ein mit der Deckenplatte wärmegekoppeltes Wärmeableitorgan vorgesehen ist, um die vom Suszeptor zur Deckenplatte transportierte Wärme abzuleiten.

Die Erfindung betrifft darüber hinaus eine Verwendung einer derartigen Vorrichtung zur Durchführung eines Beschichtungsprozesses und ein Verfahren unter Verwendung der Vorrichtung.

Die US 4,961,399 A beschreibt eine Vorrichtung zum Abscheiden von III-V-Schichten auf einer Vielzahl um ein Zentrum einer rotationssymmetrischen Prozesskammer auf auf einem Suszeptor angeordneten Substraten. Ein Gaseinlassorgan ist im Zentrum der Prozesskammer angeordnet zum Einleiten zumindest eines Hydrids, beispielsweise $NH_3$, $AsH_3$ oder $PH_3$. Durch das Gaseinlassorgan werden darüber hinaus auch metallorganische Verbindungen, beispielsweise TMGa, TMIn oder TMAl in die Prozesskammer eingeleitet. Zusammen mit diesen Prozessgasen wird auch ein Trägergas, beispielsweise Wasserstoff oder Stickstoff in die Prozesskammer eingeleitet. Der Suszeptor wird von unten her beheizt. Dies erfolgt mittels Wärmestrahlung oder mittels Hochfrequenzeinkopplung. Hinsichtlich der Anordnung einer derartigen Heizung vertikal unterhalb des Suszeptors ist auf die DE 102 47 921 A1 zu verweisen. Die Prozesskammer erstreckt sich in horizontaler Richtung und wird nach oben hin von einer Deckenplatte begrenzt. Während die US 4,961,399 eine aus Quarz gefertigte Deckenplatte beschreibt, die durch einen Horizontalspalt von einem Reaktordeckel beabstandet ist, beschreibt die DE 100 43 599 A1 beschreibt eine aus mehreren ringförmigen Elementen aufgebaute Deckenplatte, die sich unterhalb einer massiven Platte erstreckt.

Die DE 10 2004 009 130 A1 beschreibt einen MOCVD-Reaktor mit einer symmetrisch um ein zentrales Gaseinlassorgan angeordneten Prozesskammer, wobei das Gaseinlassorgan vertikal übereinander angeordnete Einlassgaszonen ausbildet. Durch die mittlere Zone wird eine III-Komponente und durch die beiden äußeren Gaseinlasszonen wird als V-Komponente ein Hydrid in die Prozesskammer eingeleitet. Die US2004/0250773 A1 beschreibt eine Vorrichtung zum Abscheiden einer Schicht auf einem Substrat, bei der das Substrat an der Decke einer Prozesskammer befestigt ist, die mit einer Heizung beheizt wird. Der Boden der Prozesskammer wird gekühlt. Der Wärmeabfluss ist als Folge eines Spaltes mit örtlich unterschiedlicher Spalthöhe örtlich verschieden.

Die US 2003/0005886 A1 beschreibt eine Vorrichtung zum Abscheiden von Halbleiterschichten auf einem Halbleitersubstrat, welches auf einem Suszeptor aufliegt, der von unten mit einer Heizung beheizt wird. Die Prozesskammerdecke wird aktiv gekühlt.

Die DE 10 2007 009145 beschreibt eine Vorrichtung zum Abscheiden kristalliner Schichten, bei der eine einem beheizten Suszeptor gegenüberliegende Prozesskammerdecke entweder aktiv gekühlt oder aktiv beheizt werden kann.

Die JP 2008/195995 beschreibt eine Vorrichtung zum Abscheiden von Halbleiterschichten in einer Prozesskammer. Die Prozesskammer besitzt eine Prozesskammerdecke, an der Substrate befestigt sind. Von oben her wird die Prozesskammerdecke mit einer Heizeinrichtung, die fünf Heizzonen aufweist, aktiv beheizt. Unterhalb des Bodens der Prozesskammer befinden sich drei Kühltanks, deren Abstand gegenüber der Bodenplatte einstellbar ist, so dass über eine Variation des Spaltes zwischen dem Kühltank und der Bodenplatte die Wärmeübertragung von der Bodenplatte zum Kühltank örtlich einstellbar ist.

Das horizontale Temperaturprofil innerhalb der Prozesskammer hängt unter anderem von der örtlichen Wärmeleistung der Heizung, also der örtlichen Wärmeübertragungsrate, ab. Die Heizung ist in unterschiedliche Heizzonen aufgeteilt, die in Stromrichtung des Prozessgases in der Prozesskammer horizontal nebeneinander liegen. Bei einer rotationssymmetrischen Prozesskammer sind die Heizzonen spiralförmig um das Zentrum angeordnet. Jede Heizzone hat eine individuelle Wärmeleistung, so dass an unterschiedlicher Stelle unterschiedliche große Energie pro Zeiteinheit in den Suszeptor eingeleitet wird. Die Energieabfuhr nach oben erfolgt durch Wärmestrahlung bzw. Wärmeleitung von der zur Prozesskammer weisenden Oberfläche des Suszeptors hin zur Prozesskammerdecke, also zur Deckenplatte. Die rückwärtig der Deckenplatte angeordnete massive Platte bzw. Reaktorwandung dient dabei als Wärmeableitorgan.

Beim Abscheiden von III-V-Schichten mit dem MOCVD-Verfahren können unerwünschte homogene Gasphasenreaktionen zwischen den verschiedenen Prozessgasen stattfinden. Werden z.B. die beiden Prozessgase $NH_3$ und TMGa miteinander vermischt, so können sich beim Zerlegen von TMGa in Anwesenheit von $NH_3$ Nebenprodukte mit $NH_3$ bilden, was als Adduktbildung bezeichnet wird. Diese Adduktbildung kann bis zur letzten/höchsten Teilzerlegungstemperatur des Metallorganikums erfolgen, so zerlegt sich TMGa beispielsweise bereits bei 100° C zunächst in DMGa und erst über eine Zerlegung über MMGa bei etwa 500° C in Ga. Die im Wege dieser Teilzerlegung entstandenen Zwischenprodukte reagieren mit dem Hydrid. Die entstandenen chemischen Verbindungen können sich in der Gasphase zusammenballen zu Klustern, was als Nukleation bezeichnet wird. Diese beiden Phänomene sind grundsätzlich bekannt, nicht jedoch die genauen Abläufe und Zusammenhänge dieser chemischen Substanzen bei der MOCVD in einer definierten Geometrie. Dieses parasitäre Verhalten der Gasphase wird verantwortlich gemacht für die Qualität des Kristallwachstums und der Begrenzung der Wachstumsrate bzw. Umsetzungseffiziens der sehr teuren Prekursoren. Zudem transportiert die Thermophoresis die entstanden Partikel entgegen dem Temperaturgradienten zu der die Prozesskammer bildenden Deckenplatte hin, wovon diese leicht herunterfallen und die Ausbeute deutlich senken und die Qualität des Kristalls beschädigen.

Eine Steigerung der Kristallqualität der abgeschiedenen Schichten setzt aber voraus, dass der Prozess bei Totaldrücken von 600 mbar und mehr durchgeführt wird, um den effektiven Gruppe V Überschuss an der Wachstumsoberfläche zu verbessern.

In einer internen Studie wurden daher die wesentlichen Zusammenhänge vom Prozess-Druck, der die freie Weglänge zwischen den Reaktanten bestimmt, von der Laufzeit des Gasgemisches in der Prozesskammer, die die Reaktionswahrscheinlichkeit bestimmt, und der Konzentration der Reaktanten, welche die Häufigkeit der Reaktion bestimmt, sowie der Isothermenverteilung in der Porzesskammer untersucht.

Die eine wesentliche Erkenntnis ist, dass sich die Menge der parasitären Verluste deutlich reduzieren lässt, wenn die Temperatur der die Prozesskammer bildende Deckenplatte auf über 500° C eingestellt wird. Dabei ist von besonderer Bedeutung, dass die radiale Temperaturverteilung sehr homogen ist. Gradienten, wie sie in den bisherigen Konstruktionen auftreten, verhindern das positive Ergebnis bei höher Temperatur an der Deckenplatte. Die andere wesentliche Erkenntnis ist, dass die parasitäre Belegung auf der die Prozesskammer bildenden Deckenplatte sich in seiner Eigenschaft von pulvrig lose zu dünnfilmfest ändert.

Um die vorteilhaften Eigenschaften durch die Prozesskammer bildende Deckenplatte sicher zu stellen, muss das thermische Management eine justierbare homogene Temperaturverteilung besitzen.

Die DE 10043599 A1 beschreibt eine zusätzliche Heizung, mit der auch die Prozesskammerdecke aufgeheizt werden kann. Wird auf eine derartige Heizung verzichtet, und wird die Deckenplatte lediglich durch den Wärmetransport vom Suszeptor her aufgeheizt, so weichen die Temperaturen in der Deckenplatte örtlich erheblich voneinander ab. Diese Temperaturgradienten führen zu einer mechanischen Belastung der Deckenplatte, und es besteht die Gefahr, dass die Deckenplatte nach einer gewissen Anzahl von Heizzyklen bricht. Zufolge des hohen Temperaturgradienten kann sich die Deckenplatte auch verformen. Bei Prozesskammerdurchmessern von 600 mm und mehr und bei hohen Totaldruckwerten in der Prozesskammer von bis zu 1000 mbar führen diese Verformungen zu einer negativen Beeinträchtigung des Schichtwachstums.

Das Wachstum auf den Substraten findet bei einer Substrattemperatur, also einer Gasphasentemperatur unmittelbar oberhalb des Substrates statt, bei welcher das Wachstum kinetisch limitiert ist. Die Temperatur ist so gewählt, dass alle über einen Diffusionsprozess durch die Grenzschicht zum Substrat gelangenden Reaktanden genügend Zeit auf der Substratoberfläche haben, um unter Ausbildung eines Einkristalls ihre thermodynamisch günstigste Position zu finden. Die Wachstumstemperatur liegt somit oberhalb derjenigen Temperatur, bei welcher der Abscheidungsprozess diffusionskontrolliert ist.

Der Erfindung liegt daher die Aufgabe zugrunde, Maßnahmen anzugeben, mit denen eine gattungsgemäße Vorrichtung zur Steigerung Kristallqualität und der Effizienz der darin durchgeführten Abscheidungsprozesse weitergebildet werden kann.

Gelöst wird die Aufgabe durch die in den Ansprüchen angegebene Erfindung. Zunächst und im Wesentlichen ist vorgesehen, dass die Wärmeleitkopplung zwischen Deckenplatte und Wärmeableitorgan örtlich verschieden ist. Dabei sind die Bereiche mit einer hohen Wärmeleitfähigkeit örtlich den Heizzonen zugeordnet sein, in denen eine hohe Wärmeleistung in den Suszeptor eingekoppelt wird. Dies hat zur Folge, dass die Deckenplatte nur durch vom Suszeptor kommende Wärme aufgeheizt wird. Dort, wo eine große Wärmemenge pro Zeiteinheit zur Deckenplatte transportiert wird, wird auch eine große Wärmemenge pro Zeiteinheit zufolge hoher Wärmeleitfähigkeit abtransportiert. Dort, wo die zur Deckenplatte transportierte Wärmemenge pro Zeiteinheit geringer ist, wird entsprechend weniger Wärme abtransportiert. Dies hat zur Folge, dass die Temperaturunterschiede an verschiedenen Orten in der Deckenplatte, also die horizontalen Temperaturgradienten niedriger sind, als beim Stand der Technik. Die Wärmeleitkopplungszonen werden von einem Horizontalspalt zwischen Deckenplatte und Wärmeableitorgan ausgebildet. Damit diese Wärmekopplungszonen örtlich verschiedene Wärmeleitfähigkeiten aufweisen, besitzt die Spalthöhe örtlich verschiedene Werte. Die Spalthöhen einer jeden Wärmeleitkopplungszone hängt von der Wärmeleistung der der jeweiligen Wärmeleitkopplungszone zugeordneten Heizzone ab. Die einander zugeordneten Wärmeleitkopplungszonen und Heizzonen liegen vertikal unmittelbar übereinander. Sind die Heizzonen ringförmig um das Zentrum angeordnet, so sind auch die Wärmeleitkopplungszonen ringförmig um das Zentrum angeordnet. Üblicherweise liefern die dem Gaseinlassorgan benachbart liegenden Heizzonen eine geringere Wärmeleistung, als diejenigen, die im Bereich unterhalb des Substrates liegen. Es sind aber nicht nur die der Gaseinlasszone zugeordneten Heizzonen, die mit verminderter Wärmeleistung arbeiten. Auch die vom Gaseinlassorgan entfernt liegenden Heizzonen, die einem Gasauslassungsorgan benachbart liegen, arbeiten mit verminderter Wärmeleistung. Infolge dessen ist die Spalthöhe des Horizontalspaltes zwischen Deckenplatte und Wärmeableitorgan im Bereich der Gaseinlasszone und im Bereich der Gasauslasszone größer als im Bereich der dazwischen liegenden Wachstumszone, in welcher Wachstumszone die Substrate angeordnet sind. Die den Horizontalspalt begrenzende untere Oberfläche des Wärmeableitorgans kann im Querschnitt auf einer gestuften oder gekrümmten Konturlinie verlaufen. Die Spalthöhe des Horizontalspaltes verändert sich dann in Stromrichtung des Prozessgases stufenförmig oder kontinuierlich. Die untere Spaltwand des Horizontalspaltes wird von der nach oben weisenden Oberfläche der Deckenplatte ausgebildet. Letztere kann eben verlaufen. Die erfindungsgemäße Vorrichtung besitzt bevorzugt einen im Wesentlichen rotationssymmetrischen Aufbau, wobei die Symmetrieachse vertikal durch das Zentrum des Gaseinlassorgans verläuft, welches eine Ausgestaltung gemäß DE 10 2004 009 130 A1 besitzen kann. Eine untere Stirnseite des Gaseinlassorgans kann in einer zentralen Vertiefung des Suszeptors einliegen, so dass das aus einer unmittelbar oberhalb der Suszeptor-Oberfläche angeordneten Einlasszone strömende Prozessgas störungsfrei in die Prozesskammer einströmen kann. Bei diesem Prozessgas handelt es sich bevorzugt um ein Hydrid, beispielsweise $NH_3$, welches zusammen mit einem Trägergas dort eingeleitet wird. Oberhalb dieser Einlasszone befindet sich eine weitere Einlasszone zum Einleiten der metallorganischen Komponente, bei der es sich um TMAl handeln kann. Unmittelbar unterhalb der Deckenplatte befindet sich eine dritte Einlasszone, durch welche wiederum das Hydrid in die Prozesskammer eingeleitet wird. Die Einlasszonen sind mit Zuleitungen verbunden. Die Hydridzuleitungen sind mit ihnen zugeordneten Gasdosiereinrichtungen eines Gasversorgungssystems verbunden. Die MO-Zuleitungen sind ebenfalls mit Dosiereinrichtungen eines Gasversorgungssystems verbunden. Sämtliche Zuleitungen sind individuell mit einem Trägergas spülbar, also mit einer Trägergaszuleitung verbunden. Der Horizontalspalt wird bevorzugt ebenfalls von einem Trägergas durchströmt. Bei dem Trägergas kann es sich um Wasserstoff, Stickstoff oder ein Edelgas oder eine Mischung dieser Gase handeln. Mit der Mischung dieser Gase kann die Wärmeleitfähigkeit innerhalb des Horizontalspaltes eingestellt werden. Zufolge dieser Maßnahmen lässt sich die Differenz zwischen Maximaltemperatur und Minimaltemperatur innerhalb der Deckenplatte auf Bereiche unter 100° C bevorzugt sogar unter 50° C beschränken. Die Deckenplatte kann einstückig aus Graphit oder aus Quarz gefertigt werden. Bei einer kreissymmetrischen Prozesskammer hat die Deckenplatte die Form einer Kreisscheibe. In einer Weiterbildung der Erfindung kann die Deckenplatte eine in Stromrichtung ansteigende Materialstärke aufweisen. Die zum Spalt weisende Seitenwand der Deckenplatte verläuft dann in einer Ebene. Die zur Prozesskammer hin weisende Wandung der Deckenplatte verläuft im Querschnitt schräg gegenüber der zur Prozesskammer weisenden Wandung des Suszeptors, so dass sich die Höhe der Prozesskammer in Stromrichtung vermindert.

Die Erfindung betrifft darüber hinaus eine Verwendung der zuvor beschriebenen Vorrichtung bei einem Abscheidungsprozess. Bei diesem Abscheidungsprozess werden durch die Einlasszonen verschiedene Prozessgase in die Prozesskammer geleitet. Durch die in Vertikalrichtung in der Mitte gelegenen Einlasszone wird eine metallorganische Verbindung, beispielsweise TMGa, TMIn, TMAl zusammen mit einem Trägergas in die Prozesskammer eingeleitet. Durch die beiden oberen und unteren Einlasszonen wird jeweils ein Hydrid zusammen mit einem Trägergas in die Prozesskammer geleitet. Bei dem Hydrid kann es sich um $NH_3$, $AsH_3$ oder $PH_3$ handeln. Die Hydridflüsse und der MO-Fluss sind individuell einstellbar. Letzteres gilt auch für den Spülgasfluss durch den Horizontalspalt. Auf eine bevorzugt drehbar auf dem Suszeptor angeordneten Substrathalter wird ein Substrat gelegt. Es können auch mehrere ringförmig um das Zentrum des Suszeptors angeordnete Substrathalter vorgesehen sein, die jeweils individuell auf einem Gaspolster schweben, durch den das Gaspolster erzeugenden Gasstrom drehangetrieben werden. Auch der Suszeptor als Solcher kann um das Symmetriezentrum der Prozesskammer drehangetrieben werden. Die unterhalb des Suszeptors angeordneten Heizungen können von Widerstandsheizungen oder RF-Heizungen gebildet sein. Die Heizungen bilden in Stromrichtung horizontal nebeneinander liegende Heizzonen aus. Bei einer rotationssymmetrischen Anordnung handelt es sich dabei um ringförmig einander umgebende Heizzonen. Die Heizzonen können auch das Zentrum der Prozesskammer spiralartig umgeben. Erfindungsgemäß werden die Heizzonen derart mit Energie versorgt, dass ihre Wärmeleistungen derart an die Wärmeableiteigenschaften der vertikal über ihnen liegenden Wärmeleitkopplungszonen angepasst sind, dass die maximale Differenz an zwei beliebigen Stellen gemessenen Temperatur in der Deckenplatte 100° C bzw. 50° C ist.

Das Wachstum auf dem Substrat findet bei Temperaturen statt, bei denen die in der Gasphase vorzerlegten Prozessgase, also insbesondere Ga oder N aufweisende Zerlegungsprodukte durch eine Diffusionszone zur Substratoberfläche diffundieren. Das Wachstum ist nicht diffusionsbegrenzt. Die Wachstumstemperatur liegt nämlich oberhalb des diffusionskontrollierten Temperaturbereichs bei einer Temperatur, bei der die Wachstumsrate kinetisch begrenzt ist. Diese Temperatur hängt sowohl von dem verwendeten Metallorganikum, als auch vom verwendeten Hydrid ab.

Die Substrattemperatur kann dabei in Bereichen von 700° C bis 1150° C liegen. Durch die Wahl eines geeigneten Spülgases durch den Horizontalspalt kann die Wärmeableitung so eingestellt werden, dass die Deckentemperatur der Prozesskammer im Bereich zwischen 500° und 800° C liegt.

Die Temperatur der Deckenplatte ist niedriger als die Temperatur des Suszeptors. Wie einleitend bereits ausgeführt, zerlegen sich die metallorganischen Komponenten schrittweise in Metallatome. So zerlegt sich beispielsweise TMGa über die Zerlegungsprodukte DMGa und MMGa in Ga. Die Zerlegung beginnt bei etwa 100° C. Bei einer Temperatur von etwa 500° C ist der Ausgangsstoff vollständig zerlegt. Zwischen diesen beiden Temperaturen befinden sich die Zerlegungsprodukte, beispielsweise DMGa und MMGa, in der Gasphase. In diesem Temperaturbereich kann es somit zur Adduktbildung, zur nachfolgenden Nukleation und zu der zu vermeidenden Verclusterung kommen. Dieser Temperaturbereich ist von dem verwendeten Metallorganikum abhängig. Die Deckentemperatur wird so gewählt, dass sie oberhalb dieser Adduktbildungstemperatur liegt, also bei einer Temperatur, bei der sich keine Zwischenzerlegungsprodukte in der Gasphase befinden. Die Oberflächentemperatur der Deckenplatte ist aber nicht nur nach unten, sondern auch nach oben begrenzt. Ihre Temperatur soll in einem Temperaturbereich liegen, bei dem das Kristallwachstum diffusionsbegrenzt ist. Die Temperatur liegt also in einem der Diffusionsbegrenzung äquivalenten Temperaturbereich und damit unterhalb der Suszeptortemperatur, die im kinetisch limitierten Temperaturbereich liegt.

Ausführungsbeispiele der Erfindung werden anhand beigefügter Zeichnungen erläutert. Es zeigen:

Fig. 1 die rechte Seite eines Querschnitts durch eine um die Achse 19 rotationssymmetrische Prozesskammer eines ersten Ausführungsbeispiels;

Fig. 2 einen Querschnitt eines zweiten Ausführungsbeispiels der Erfindung;

Fig. 3 einen Querschnitt eines dritten Ausführungsbeispiels der Erfindung;

Fig. 4 einen Querschnitt eines vierten Ausführungsbeispiels der Erfindung und

Fig. 5 einen Querschnitt eines fünften Ausführungsbeispiels der Erfindung.

Der grundsätzliche Aufbau eines MOCVD-Reaktors, wie ihn die Erfindung betrifft, ist aus dem eingangs genannten Stand der Technik bekannt, weshalb diesbezüglich unter anderem darauf verwiesen wird.

Der MOCVD-Reaktor der Ausführungsbeispiele besitzt einen Suszeptor 2, der aus einer kreisscheibenförmigen Graphit- oder Quarzplatte besteht, die um eine Drehachse 19 drehangetrieben werden kann. Bei der Drehachse 19 handelt es sich um die Symmetrieachse des gesamten Reaktors. In der Symmetrieachse 19 des Reaktors erstreckt sich das Gaseinlassorgan 4. Eine untere Stirnseite des Gaseinlassorgans 4 liegt in einer Vertiefung 18 des Suszeptors 2, so dass die unmittelbar darüber liegende Einlasszone 12 in den bodennahen Bereich des Suszeptors 2 mündet. Oberhalb dieser Einlasszone 12, durch die ein Hydrid, beispielsweise $NH_3$, $AsH_3$ oder $PH_3$ in die Prozesskammer 1 eingeleitet wird, befindet sich eine zweite Einlasszone 11, durch die eine metallorganische Komponente, beispielsweise TMGa, TMIn oder TMAl in die Prozesskammer 1 eingeleitet werden kann. Unmittelbar an einer, die Prozesskammer 1 nach oben begrenzenden Deckenplatte 3 grenzt eine dritte Einlasszone 10 an, durch die ebenfalls eines der vorgenannten Hydride in die Prozesskammer 1 eingeleitet werden kann.

Die Prozesskammer 1 erstreckt sich somit in horizontaler Richtung ringförmig um das Gaseinlassorgan 4 und zwischen dem sich in Horizontalrichtung erstreckenden Suszeptor 2 und der sich vom Suszeptor 2 beabstandet ebenfalls in Horizontalrichtung erstreckenden Deckenplatte 3.

Oberhalb der Deckenplatte 3 ist ein Wärmeableitorgan 8 angeordnet. Es kann sich dabei um einen flüssigkeitsgekühlten Festkörper handeln. Der Festkörper ist mit geeigneten Halterungen an den nicht dargestellten Reaktorwänden befestigt und besitzt in seinem Inneren Kanäle, die von einem flüssigen Kühlmittel durchströmt werden.

Das Wärmeableitorgan 8, welches beispielsweise auch aus Quarz oder aus Stahl besteht, besitzt eine gewölbte Unterseite 8'. Diese Unterseite 8' ist von der eben verlaufenden oberen Wandung 3' der Deckenplatte 3 beabstandet, so dass sich ein Horizontalspalt 9 ausbildet.

In einem eine Gaseinlasszone ausbildenden Bereich, der unmittelbar dem Gaseinlassorgan 4 benachbart ist, besitzt der Horizontalspalt 9 eine sich kontinuierlich mit dem Abstand vom Gaseinlassorgan 4 verminderte Spalthöhe $S_1$, $S_2$. Die beiden der Gaseinlasszone zugeordneten Wärmeleitkopplungszonen $Z_1$ und $Z_2$ besitzen somit unterschiedliche Wärmeleiteigenschaften. Die erste Zone $Z_1$ besitzt zufolge ihrer großen Spalthöhe $S_1$ eine geringere Wärmeleitfähigkeit, als die daneben liegende Wärmeleitkopplungszone $Z_2$, der eine gegenüber der $S_1$ geringere Spalthöhe $S_2$ zugeordnet ist.

Unterhalb einer jeden Wärmeleitkopplungszone $Z_1$ - $Z_8$, die sich ringförmig um das Gaseinlassorgan 4 erstrecken, liegen jeweils Heizzonen $H_1$ - $H_8$. Die Heizzonen $H_1$ - $H_8$ werden von Widerstandsheizungen oder von RF-Heizspulen ausgebildet. Die Heizzonen $H_1$ - $H_8$ erzeugen voneinander verschiedene Wärmeleistungen

$$\dot{Q}_1 - \dot{Q}_8.$$ Die von den Heizzonen H1 und H2 erzeugten Wärmeleistungen $\dot{Q}_1$ und $\dot{Q}_2$ sind geringer, als die Wärmeleistungen $\dot{Q}_3$, $\dot{Q}_4$, $\dot{Q}_5$ und $\dot{Q}_6$, die von den mittleren Heizzonen $H_3$, $H_4$, $H_5$ und $H_6$ erzeugt werden. Diese Heizzonen befinden sich unmittelbar unterhalb der ringförmig um die Drehachse 19 angeordneten Substrate 5, wobei die Substrate 5 jeweils auf drehangetriebenen Substrathaltern 6 aufliegen. Der Drehantrieb der Substrathalter 6 erfolgt über Gasströme, so dass die Substrathalter 6 auf einem Gaspolster gelagert sind.

Vertikal oberhalb der dieser Wachstumszone zugeordneten Heizzonen $H_3$ - $H_6$ befinden sich die Wärmeleitkopplungszonen $Z_3$ - $Z_6$. Die diesen Wärmeleitkopplungszonen $Z_3$ - $Z_6$ zugeordneten Spalthöhen $S_3$, $S_4$, $S_5$ und $S_6$ sind geringer, als die Spalthöhen der Wärmeleitkopplungszone $Z_1$ und $Z_2$, und niedriger als die Spalthöhen $S_7$ und $S_8$ der beiden radial äußersten Wärmeleitkopplungszonen $Z_7$ und $Z_8$.

Den radial zuäußerst liegenden Wärmeleitkopplungszonen $Z_7$ und $Z_8$ sind Heizzonen $H_7$ und $H_8$ zugeordnet, die in einer Gasauslasszone der Prozesskammer 1 angeordnet sind. Die Gasauslasszone befindet sich in Stromrichtung jenseits der Substrate 5. Die von diesen Heizzonen $H_7$ und $H_8$ in den Suszeptor eingekoppelte Wärmeleistung $\dot{Q}_7$ und $\dot{Q}_8$ ist geringer als die von den mittleren Heizzonen $H_3$ bis $H_6$ in den Suszeptor 2 eingekoppelten Wärmeleistungen $\dot{Q}_3$ - $\dot{Q}_6$. Die Gasauslasszone ist von einem ringförmigen Gasauslassorgan 17 umgeben.

In den Ausführungsbeispielen sind die einzelnen Heizzonen $H_1$ bis $H_8$ etwa gleich weit voneinander entfernt. Entsprechendes gilt für die Wärmeleitkopplungszonen $Z_1$ - $Z_8$, die ebenfalls eine im Wesentlichen identische radiale Erstreckungsweite aufweisen. Wesentlich ist, dass zu jeder Heizzone $H_1$ eine ihr individuell zugeordnete Wärmeleitkopplungszone $Z_1$ - $Z_8$ existiert, wobei die Spaltweite $S_1$ - $S_8$ der jeweiligen Wärmeleitkopplungszone $Z_1$ - $Z_8$ an die Wärmeleistung $\dot{Q}_1$ - $\dot{Q}_8$ der jeweiligen Heizzone $H_1$ - $H_8$ angepasst ist. Die Anpassung erfolgt derart, dass der laterale Temperaturgradient in der Deckenplatte 3 minimiert ist und insbesondere die maximale Temperaturdifferenz bei etwa 100° C, bevorzugt niedriger, nämlich bei 50° C liegt.

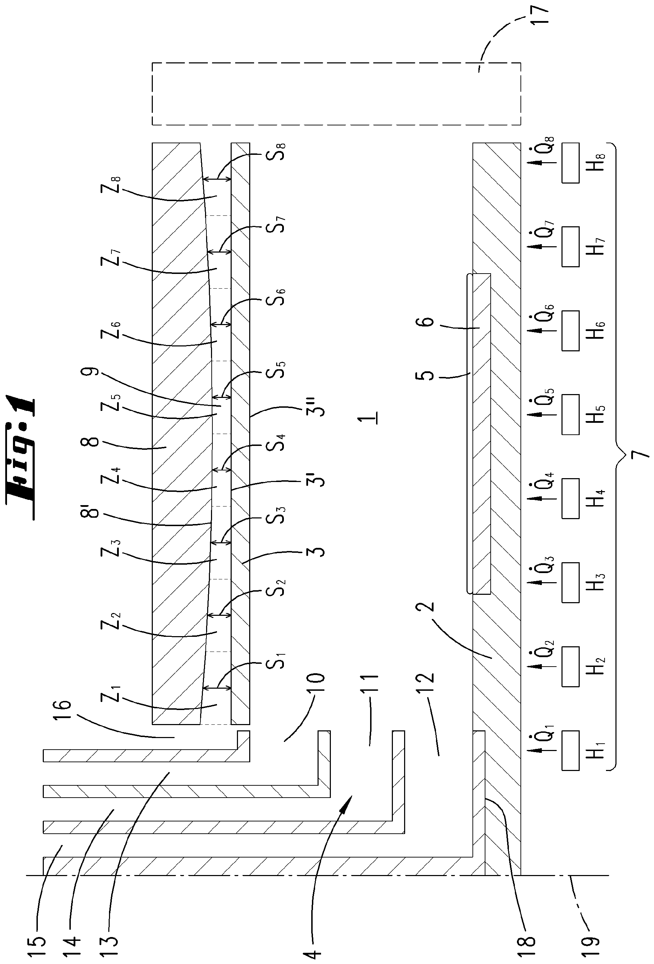

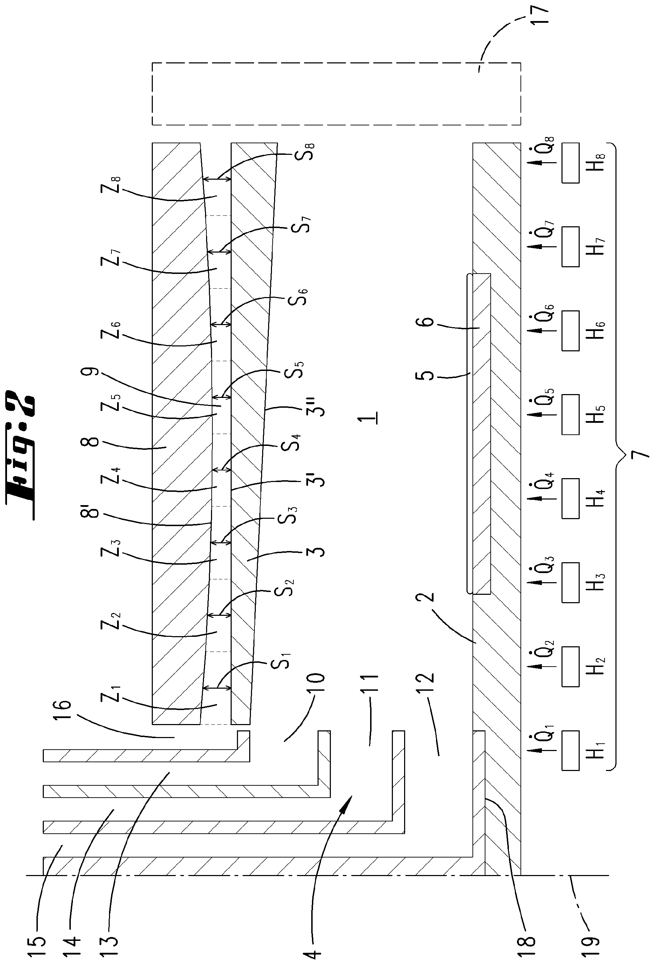

Grundsätzlich wird innerhalb der Gaseinlasszone und der Gasauslasszone eine geringere Wärmemenge pro Zeiteinheit in den Suszeptor eingeleitet, als in der Wachstumszone, in welcher sich die Substrate 5 befinden. Dabei kann die Wärmeleistung, die in die Gaseinlasszone eingekoppelt wird, aber größer sein, als die Wärmeleistung, die in die Gasauslasszone eingekoppelt wird. In den in den Figuren 1 und 2 dargestellten Ausführungsbeispielen verläuft die Wandung 8' des Wärmeableitorgans 8 entlang einer Thorus-Oberfläche. Die den Horizontalspalt 9 nach oben begrenzende Wandung 8' ist somit gewölbt. Im radial mittleren Bereich des Horizontalspaltes 9 hat letzterer seine minimale Spalthöhe. An den beiden radialen Enden hat der Horizontalspalt 9 seine größte Spalthöhe. Entsprechend besitzen die Wärmeleitkopplungszonen im mittleren Bereich die größte Wärmeleitfähigkeit und an den radialen Rändern die geringste Leitfähigkeit.

Das in der Fig. 2 dargestellte zweite Ausführungsbeispiel unterscheidet sich vom ersten Ausführungsbeispiel lediglich durch den Verlauf des Horizontalspaltes 9 im Bereich stromabwärts etwa der Mitte der Prozesskammer 1. Hier verläuft die Krümmung der Wandung 8' etwas flacher, als im ersten Ausführungsbeispiel, so dass die Spalthöhe des Horizontalspaltes 9 in Stromrichtung geringer ansteigt. Ein weiterer, wesentlicher Unterschied ist die Gestalt der ringförmigen Deckenplatte 3. Auch hier ist die Deckenplatte 3 einstückig und kann von einer einzigen ringförmigen Quarz- oder Graphitplatte gebildet sein. Während bei dem in der Fig. 1 dargestellten ersten Ausführungsbeispiel die beiden Breitseiten der Deckenplatte 3 parallel zueinander und parallel zur Oberseite des Suszeptors 2 verlaufen, verläuft die zur Prozesskammer 1 weisende Wandung 3" der Deckenplatte 3 im Querschnitt schräg zu der den Horizontalspalt 9 begrenzenden Wandung 3'. Dies hat zur Folge, dass sich die vertikale Höhe der Prozesskammer 1 in Stromrichtung vermindert.

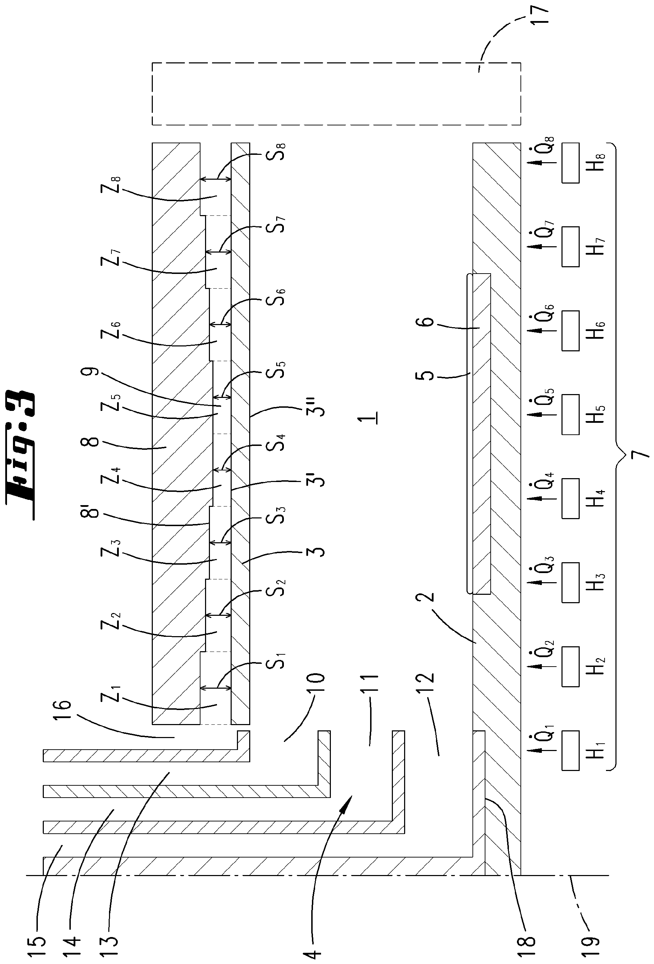

Das in der Fig. 3 dargestellte Ausführungsbeispiel unterscheidet sich von dem in Fig. 1 dargestellten Ausführungsbeispiel durch den Verlauf der zum Horizontalspalt 9 hinweisenden Breitseitenfläche 8' des Wärmeableitorgans 8. Diese Breitseite ist mit ringförmig um die Zentrumslinie 19 verlaufenden Stufen versehen, wobei die Stufen unterschiedliche Abstände $S_1$ - $S_8$ zur Breitseitenfläche 3' der Deckenplatte 3 besitzt.

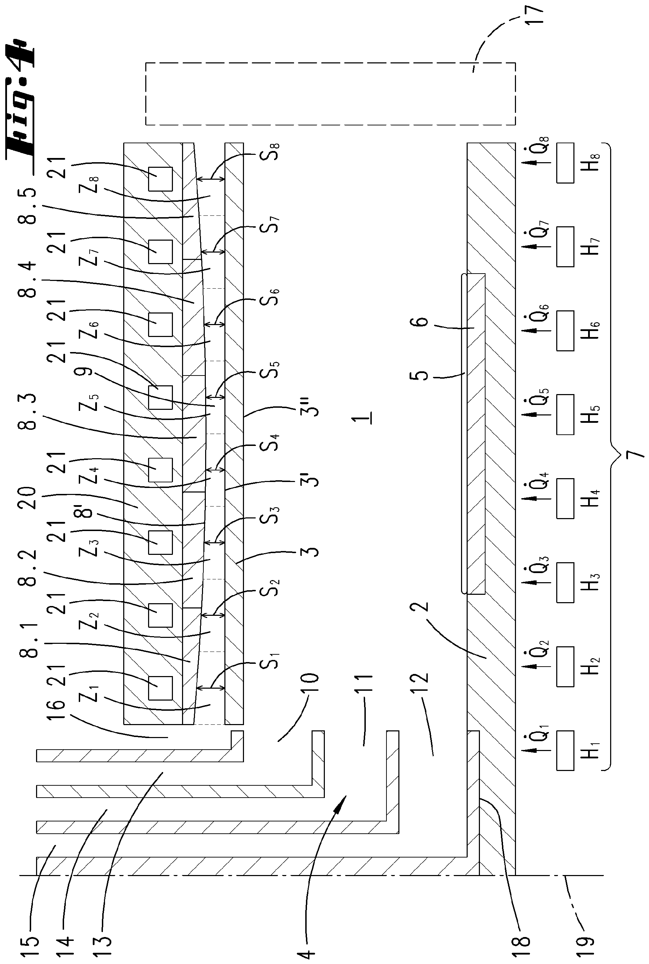

Bei dem in der Fig. 4 dargestellten Ausführungsbeispiel besteht das Wärmeableitorgan 8 aus einer Vielzahl ringförmig ineinander geschachtelt angeordneter Elemente. Es kann aber auch hier einstückig ausgebildet sein. Das Wärmeableitorgan 8 ist bei diesem Ausführungsbeispiel nicht direkt mit einem flüssigen Kühlmedium gekühlt, sondern wärmeübertragend mit der Reaktorwand verbunden, beispielsweise unter die Reaktorwand 20 geschraubt. Die Reaktorwand 20 besitzt Kühlkanäle 21, durch welche ein flüssiges Kühlmedium strömt, um die Reaktorwand zu kühlen. Die Reaktorwand besteht beispielsweise aus Aluminium oder aus Edelstahl. Das Wärmeableitorgan 8, welches aus mehreren Teilbereichen 8.1 - 8.5 bestehen kann, besteht beispielsweise aus Aluminium, Graphit oder einem ähnlich gut wärmeleitenden Material. Die Deckenplatte 3 besteht bei diesem Ausführungsbeispiel ebenfalls bevorzugt aus Graphit. Sie kann aber auch aus Quarz bestehen. Bevorzugt ist die Deckenplatte 3 mit SiC, TAC beschichtet. Die Temperaturen der Deckenplatte liegen für den Prozess mit $NH_3$ und TMGa, also zum Abscheiden von GaN zwischen 450° C und 800° C. Für den Prozess mit AsH3 und PH$_3$ zur Abscheidung von GaAs oder InP liegen die Temperaturen der Deckenplatte im Bereich zwischen 150° C und 550° C.

In beiden Fällen ist die Oberflächentemperatur der Deckenplatte 3 gewählt, dass sie oberhalb der Adduktbildungstemperatur liegt. Letztere ist definiert durch die Temperatur, bei der die metallorganische Komponente vollständig zerfallen ist; eine Temperatur, bei der in der Gasphase so gut wie keine Zwischenprodukte vorhanden sind, die mit dem Hydrid in der Gasphase reagieren könnten, so dass es in Folge eines Nukleationsprozesses zu einer Verclusterung kommen könnte. Die Oberflächentemperatur der Deckenplatte ist aber auch nach oben begrenzt. Sie soll nicht in dem Bereich liegen, bei dem auf einem Substrat das Wachstum kinetisch limitiert ist. Die Temperatur soll vielmehr in einem Bereich liegen, bei der in Anwesenheit eines Substrates das Wachstum diffusionslimitiert ist, also durch den Massentransport der Reaktanden durch die Diffusionsgrenzfläche.

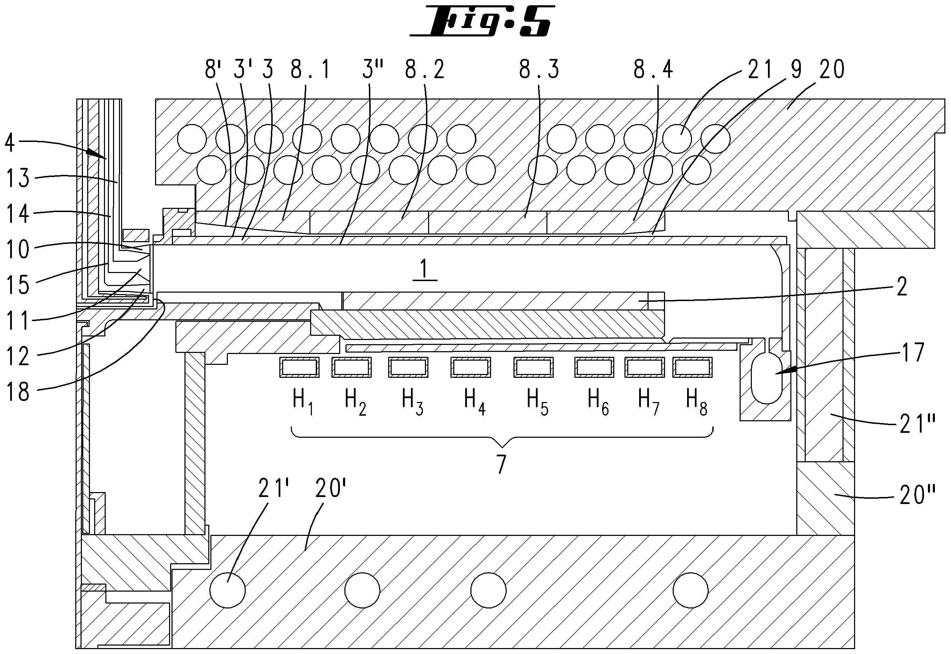

Das in der Fig. 5 dargestellte Ausführungsbeispiel entspricht im Wesentlichen dem in der Fig. 4 dargestellten Ausführungsbeispiel. Auch hier besitzt der Reaktor ein aus Aluminium gefertigtes Gehäuse mit einer Gehäusedecke 20 und einem dazu parallelen Gehäuseboden 20'. Eine rohrförmige Gehäusewand 20" befindet sich zwischen Gehäusedecke 20 und Gehäuseboden 20'. In der Gehäusedecke befindet sich eine Vielzahl von Kühlkanälen 21, die mit einem Kühlmedium, bspw. Kühlwasser, durchströmt sind. Auch im Gehäuseboden 20' und in der Gehäusewand 20" befinden sich derartige Kühlkanäle 21', 21".

Mit Abstand oberhalb des Gehäusebodens 21' erstreckt sich eine von einer spiralförmigen Spule ausgebildete Heizung 7, die insgesamt acht Windungen aufweist. Jede einzelne Windung bildet eine Heizzone H$_1$ - H$_8$ aus, die bauartbedingt oder auch toleranzbedingt eine individuelle Leistung abgibt. Handelt es sich hierbei um eine Widerstandsheizung, so erfolgt die Leistungsabgabe im Wesentlichen als Wärmestrahlung. Handelt es sich bei der Heizung um eine RF-Spule, wird ein elektromagnetisches Wechselfeld erzeugt, welches in den oberhalb der Heizung 7 angeordneten Suszeptor 1 Wirbelströme erzeugt.

Das RF-Strahlungsfeld ist inhomogen, so dass innerhalb des Suszeptors 1 Zonen entstehen, in die eine unterschiedlich hohe Leistung eingekoppelt werden. Diese Zonen, die insbesondere rotationssymmetrisch um das Zentrum der Prozesskammer angeordnet sind, erwärmen sich verschieden stark, so dass der Suszeptor 1 in Radialrichtung ein inhomogenes Temperaturprofil aufweist.

Es ist insbesondere vorgesehen, dass in einer ersten, sich unmittelbar um das Gaseinlassorgan erstreckenden Gaseinlasszone der Suszeptor eine niedrigere Oberflächentemperatur aufweist als in einer sich daran anschließenden Wachstumszone. In der radial äußersten Zone, die sich der Wachstumszone anschließt, besitzt der Suszeptor wiederum eine geringere Oberflächentemperatur.

Die Wärmeableitung erfolgt, wie oben bereits beschrieben, durch die Deckenplatte 3 und einen zwischen Deckenplatte 3 und einem Wärmeableitorgan 8 befindlichen Spalt 9.

Das Wärmeableitorgan 8 besteht aus insgesamt vier Ringelementen 8.1, 8.2, 8.3, 8.4, die untereinander die gleiche Breite besitzen, aber ein anderes Querschnittsprofil aufweisen, so dass die Höhe des Spaltes 9 über den radialen Abstand vom Zentrum der Prozesskammer variiert. Der radial innerste Ring 8.1 des Wärmeableitorganes 8 besitzt die größte Steigung und hat die geringste Materialstärke. Hier ist die Spaltweite am größten. Die Spaltweite vermindert sich keilartig bis hin in den Bereich des zweiten Wärmeableitringes 8.2. Etwa von dessen Mitte erstreckt sich über den dritten Wärmeableitring 8.3 bis hin etwa zur Mitte des vierten Wärmeableitrings 8.4 ein Bereich gleichbleibender Höhe des Spaltes 9, der der Wachstumszone zugeordnet ist. Der vierte Wärmeableitring 8.4 besitzt eine Breitseitenfläche 8', die radial ansteigt, so dass der Spalt 9 eine mit steigendem Radius ansteigende Spalthöhe besitzt. Im Bereich des Gasauslassringes 17 fehlt das Wärmeableitorgan 8. Hier hat der Spalt seine Maximalhöhe und erstreckt sich zwischen Deckenplatte 3 und Innenseite der Reaktordecke 20.

Bei diesem Ausführungsbeispiel ist die Radialquerschnittskontur des Spaltes 9 so gewölbt, dass die Oberflächentemperatur an der Unterseite der Deckenplatte 3" in Radialrichtung nur geringfügig, nämlich nahezu linear von etwa 500°C im Bereich des Gaseinlasses 4 auf etwa 600°C im Bereich des Gasauslasses 17 ansteigt.

Auf der Oberfläche des Suszeptors steigt hingegen die Temperatur von etwa 500°C im Bereich des Gaseinlasses auf etwa 1.000°C zu Beginn der Wachstumszone an und bleibt über die Wachstumszone hinweg konstant bei etwa 1.000°C.

**Bezugszeichenliste**

| | |
|---|---|
| 1 | Prozesskammer |
| 2 | Suszeptor |
| 3 | Deckenplatte |
| 4 | Gaseinlassorgan |
| 5 | Substrat |
| 6 | Substrathalter |
| 7 | Heizung |
| 8 | Wärmeableitorgan |
| 9 | Horizontalspalt |
| 10 | Einlasszone |
| 11 | Einlasszone |
| 12 | Einlasszone |
| 13 | Hydridzuleitung |

| 14 | Gaseinlassorgan |
|---|---|
| 15 | Hydridzuleitung |
| 16 | Spülgaseinlass |
| 17 | Gasauslassorgan |
| 18 | Vertiefung |
| 19 | Zentrum / Drehachse / Symmetrieachse |
| 20 | Reaktorwand |
| 21 | Kühlkanal |

H　　　　　　Heizung
$Z_1$ bis $Z_8$　Wärmeleitkopplungszonen
$S_1$ bis $S_8$　Spalthöhen
$H_1$ bis $H_8$　Heizzonen

**Patentansprüche**

**1.** Vorrichtung zum Abscheiden mindestens einer, insbesondere kristallinen Schicht auf mindestens einem Substrat (5), mit einem den Boden einer Prozesskammer (1) bildenden Suszeptor (2) zur Aufnahme des mindestens einen Substrates (5), mit einer die Decke der Prozesskammer (1) bildenden Deckenplatte (3) und mit einem Gaseinlassorgan (4) zum Einleiten von sich in der Prozesskammer zufolge Wärmezufuhr in die schichtbildende Komponenten zerlegenden Prozessgasen und eines Trägergases, wobei unterhalb des Suszeptors (2) eine Vielzahl von nebeneinander liegenden Heizzonen ($H_1$ - $H_8$) angeordnet sind, mittels derer verschieden hohe Wärmeleistungen $(\dot{Q}_1 - \dot{Q}_8)$ in den Suszeptor (2) eingeleitet werden, um dessen zur Prozesskammer (1) weisende Oberfläche und das sich in der Prozesskammer (1) befindende Gas aufzuheizen, wobei oberhalb der Deckenplatte (3) Wärmeleitkopplungszonen ($Z_1$ - $Z_8$) vorgesehen sind, um die vom Suszeptor (2) zur Deckenplatte (3) transportierte Wärme abzuleiten, wobei die Wärmekopplungszonen ($Z_1$ - $Z_8$) einen Horizontalspalt (9) zwischen Deckenplatte (3) und Wärmeableitorgan (8) mit örtlich verschiedenen Spalthöhen ($S_1$ - $S_8$) aufweisen, und die Spalthöhen ($S_1$ - $S_8$) von der Wärmeleistung $(\dot{Q}_1 - \dot{Q}_8)$ der jeweiligen vertikal unterhalb der Wärmeleitkopplungszonen ($Z_1$ - $Z_8$) liegenden Heizzonen ($H_1$ - $H_8$) derart abhängen, dass die Wärmeleitkopplungszonen ($Z_3$, $Z_4$, $Z_5$, $Z_6$) hoher Wärmeleitfähigkeit örtlich zu Heizzonen ($H_3$, $H_4$, $H_5$, $H_6$) hoher Wärmeleistung $(\dot{Q}_3, \dot{Q}_4, \dot{Q}_5, \dot{Q}_6)$ korrespondieren und Wärmeleitkopplungszonen ($Z_1$, $Z_2$) niedriger Wärmeleitfähigkeit örtlich zu Heizzonen ($H_1$, $H_2$) niedriger Wärmeleistung $(\dot{Q}_1, \dot{Q}_2)$ korrespondieren, **dadurch gekennzeichnet, dass** der Horizontalspalt (9) an einem Spülgaseinlass (16) angeschlossen ist, um ein Spülgas durch den Horizontalspalt (9) hindurchströmen zu lassen.

**2.** Vorrichtung nach Anspruch 1, **dadurch gekennzeichnet, dass** Spalthöhen ($S_1$, $S_2$) im Bereich einer dem Gaseinlassorgan (4) benachbarten Gaseinlasszone und die Spalthöhen ($S_7$, $S_8$) im Bereich einer vom Gaseinlassorgan (4) entfernt liegenden Gasauslasszone größer sind, als die Spalthöhen ($S_3$ - $S_6$) einer zwischen Gaseinlasszone und Gasauslasszone angeordneten Wachstumszone, in welcher das mindestens eine Substrat (5) angeordnet ist.

**3.** Vorrichtung nach einem der vorhergehenden Ansprüche, **dadurch gekennzeichnet, dass** die zur Deckenplatte (3) weisende, den Horizontalspalt (9) begrenzende Oberfläche des Wärmeableitorgans (8) gestuft oder glattwandig gekrümmt verläuft.

**4.** Vorrichtung nach einem der vorhergehenden Ansprüche, **gekennzeichnet durch** einen zentrumssymmetrischen Aufbau der Prozesskammer, wobei das Gaseinlassorgan (4) im Symmetriezentrum angeordnet ist, um welches die kreisförmig gestaltete Deckenplatte (3) und das kreisförmig gestaltete, insbesondere von nebeneinander liegenden Ringen gebildete Wärmeableitorgan (8) angeordnet ist.

**5.** Vorrichtung nach einem der vorhergehenden Ansprüche, **dadurch gekennzeichnet, dass** das Gaseinlassorgan (4) an mindestens einer Hydridzuleitung (13, 15) und einer MO-Zuleitung (14) angeschlossen ist, wobei die mindestens eine Hydridzuleitung (13, 15) in eine ihr zugeordnete Einlasszone (10, 12) mündet, und die MO-Zuleitung (14) in eine ihr zugeordnete Einlasszone (11) mündet, wobei bevorzugt der MO-Einlass zone (11) vertikal beidseitig eine Einlasszone (10, 12) für das Hydrid benachbart ist.

**6.** Vorrichtung nach einem der vorhergehenden Ansprüche, **dadurch gekennzeichnet, dass** die Deckenplatte (3) aus Graphit oder Quarz besteht und insbesondere aus einem Stück gefertigt ist.

**7.** Vorrichtung nach einem der vorhergehenden Ansprüche, **dadurch gekennzeichnet, dass** die vertikale Höhe der Prozesskammer (1) in Stromrichtung des aus dem Gaseinlassorgan (14) austretenden Prozessgases in Richtung eines Gasauslassorgans (17) abnimmt.

**8.** Vorrichtung nach einem der vorhergehenden Ansprüche, **dadurch gekennzeichnet, dass** die Heizung (7) von einer Vielzahl das Zentrum (19) der Prozesskammer (1) ringförmig umgebenden Heizzonen (H$_1$ - H$_8$) ausgebildet ist.

**9.** Verwendung einer Vorrichtung gemäß einem der vorhergehenden Ansprüche, **dadurch gekennzeichnet, dass** in der Vorrichtung durch Einleiten von Prozessgasen in das Gaseinlassorgan (4) und durch thermisches Zerlegen der Prozessgase in der Prozesskammer (1) in die schichtbildenden Komponenten ein Schichtwachstum auf mindestens einem Substrat stattfindet, wobei die Wärmeleistungen $\dot{Q}_1 - \dot{Q}_8$ der Heizzonen (H$_1$ - H$_8$) so gewählt sind, dass die maximale Differenz an zwei beliebigen Stellen der an der Deckenplatte gemessenen Temperaturen 100° C, bevorzugt 50° C, ist.

**10.** Verwendung nach Anspruch 9, **dadurch gekennzeichnet, dass** die Temperatur an der Deckenplatte (3) über ihrer gesamten Fläche oberhalb der Adduktbildungstemperatur der verwendeten Prozessgase liegt und unterhalb der Temperatur, bei welcher das Kristallwachstum auf einem Substrat kinetisch begrenzt ist und insbesondere bspw. für GaN im Bereich zwischen 500° und 800° C und bei GaAs oder InP zwischen 150° C und 550° C.

**11.** Verfahren zum Abscheiden mindestens einer insbesondere kristallinen Schicht auf mindestens einem Substrat (5) unter Verwendung einer Vorrichtung gemäß einem der Ansprüche 1 bis 8,, **dadurch gekennzeichnet, dass** die Deckenplatte (3) auf ihrer gesamten zur Prozesskammer (1) weisenden Fläche eine Temperatur besitzt, die oberhalb der Adduktbildungstemperatur der Prozessgase liegt, jedoch unterhalb einer Temperatur, bei der das Kristallwachstum auf einem Substrat kinetisch begrenzt ist.

**Claims**

**1.** Device for depositing at least one, in particular crystalline, layer on at least one substrate (5), comprising a susceptor (2) for receiving the at least one substrate (5), which susceptor forms the floor of a process chamber (1), comprising a cover plate (3) which forms the cover of the process chamber (1), and comprising a gas inlet member (4) for introducing process gases, which decompose into the layer-forming components in the process chamber as a result of heat supply, and a carrier gas, a plurality of adjacent heating zones (H$_1$-H$_8$) being arranged below the susceptor (2), by means of which zones differently high thermal outputs ($\dot{Q}_1$-$\dot{Q}_8$) are introduced into the susceptor (2) in order to heat the surface thereof facing the process chamber (1) and the gas in the process chamber (1), heat-conveying coupling zones (Z$_1$-Z$_8$) being provided above the cover plate (3) in order to dissipate the heat transported from the susceptor (2) to the cover plate (3), the heat coupling zones (Z$_1$-Z$_8$) having a horizontal gap (9) between the cover plate (3) and heat-dissipating member (8), which gap has locally different gap heights (S$_1$-S$_8$), and the gap heights (S$_1$-S$_8$) being dependent on the thermal output ($\dot{Q}_1$-$\dot{Q}_8$) of the respective heating zones (H$_1$-H$_8$) vertically below the heat-conveying coupling zones (Z$_1$-Z$_8$) such that the heat-conveying coupling zones (Z$_3$, Z$_4$, Z$_5$, Z$_6$) of higher thermal conductivity locally correspond to heating zones (H$_3$, H$_4$, H$_5$, H$_6$) of higher thermal output ($\dot{Q}_3$, $\dot{Q}_4$, $\dot{Q}_5$, $\dot{Q}_6$) and heat-conveying coupling zones (Z$_1$, Z$_2$) of low thermal conductivity locally correspond to heating zones (H$_1$, H$_2$) of low thermal output ($\dot{Q}_1$, $\dot{Q}_2$), **characterised in that** the horizontal gap (9) is attached to a purge gas inlet (16) in order to allow a purge gas to flow through the horizontal gap (9).

**2.** Device according to claim 1, **characterised in that** gap heights (S$_1$, S$_2$) in the region of a gas inlet zone adjacent to the gas inlet member (4) and the gap heights (S$_7$, S$_8$) in the region of a gas outlet zone remote from the gas inlet member (4) are greater than the gap heights (S$_3$-S$_6$) of a growth zone arranged between the gas inlet zone and gas outlet zone, in which growth zone the at least one substrate (5) is arranged.

**3.** Device according to either of the preceding claims, **characterised in that** the surface of the heat-dissipating member (8) that faces the cover plate (3) and defines the horizontal gap (9) extends in a stepped or curved smooth-walled manner.

**4.** Device according to any of the preceding claims, **characterised by** a central-symmetrical design of the process chamber, the gas inlet member (4) being arranged in the centre of symmetry, around which the circular cover plate (3) and the circular heat-dissipating member (8), in particular formed by adjacent rings, is arranged.

**5.** Device according to any of the preceding claims, **characterised in that** the gas inlet member (4) is attached to at least one hydride supply line (13, 15) and an MO supply line (14), the at least one hydride supply line (13, 15) opening into an inlet zone (10, 12) associated therewith, and the MO supply line (14) opening into an inlet zone (11) associated therewith, the MO inlet zone (11) preferably vertically adjoining an inlet zone (10, 12) for the hydride on both sides.

6. Device according to any of the preceding claims, **characterised in that** the cover plate (3) consists of graphite or quartz and is manufactured in particular from one piece.

7. Device according to any of the preceding claims, **characterised in that** the vertical height of the process chamber (1) decreases in the direction of flow of the process gas exiting from the gas inlet member (14) in the direction of a gas outlet member (17).

8. Device according to any of the preceding claims, **characterised in that** the heating system (7) is formed by a plurality of heating zones ($H_1$-$H_8$) annularly surrounding the centre (19) of the process chamber (1).

9. Use of a device according to any of the preceding claims, **characterised in that** a layer growth occurs on at least one substrate in the device by introducing process gases into the gas inlet member (4) and by thermally decomposing the process gases in the process chamber (1) into the layer-forming components, the thermal outputs $\dot{Q}_1$-$\dot{Q}_8$ of the heating zones ($H_1$-$H_8$) being selected such that the maximum difference at any two points between the temperatures measured on the cover plate is 100°C, preferably 50°C.

10. Use according to claim 9, **characterised in that** the temperature on the cover plate (3) over the entire surface thereof is greater than the adduct-forming temperature of the used process gases and less than the temperature at which the crystal growth on a substrate is kinetically limited and in particular for example for GaN in the range between 500° and 800°C and for GaAs or InP between 150° and 550°C.

11. Method for depositing at least one, in particular crystalline, layer on at least one substrate (5) using a device according to any of claims 1 to 8, **characterised in that** the cover plate (3), over the entire surface thereof that faces the process chamber (1), has a temperature which is greater than the adduct-forming temperature of the process gases but is less than a temperature at which the crystal growth on a substrate is kinetically limited.

**Revendications**

1. Dispositif de dépôt d'au moins une couche, en particulier cristalline, sur au moins un substrat (5), le dispositif comprenant un suscepteur (2) formant le fond d'une chambre de traitement (1) et destiné à recevoir l'au moins un substrat (5), une plaque de plafond (3) formant le plafond de la chambre de traitement (1) et un élément d'admission de gaz (4) destiné à introduire des gaz de traitement, qui se décomposent dans la chambre de traitement en les composants formant la couche en raison de l'apport de chaleur, et un gaz porteur, une pluralité de zones de chauffage ($H_1$ - $H_2$) étant disposées les unes à côté des autres au-dessous du suscepteur (2), au moyen desquelles différentes puissances calorifiques élevée ($\dot{Q}_1$ - $\dot{Q}_8$) sont introduites dans le suscepteur (2) pour chauffer la surface de celui-ci, tournée vers la chambre de traitement (1) et le gaz se trouvant dans la chambre de traitement (1), des zones de couplage thermique ($Z_1$ - $Z_8$) étant prévues au-dessus de la plaque de plafond (3) pour évacuer la chaleur transportée du suscepteur (2) à la plaque de plafond (3),
les zones de couplage thermique ($Z_1$ - $Z_8$) comportant une fente horizontale (9) ménagée entre la plaque de plafond (3) et un élément d'évacuation de chaleur (8) et ayant des hauteurs de fente localement différentes ($S_1$ - $S_8$) et les hauteurs de fente ($S_1$ - $S_8$) dépendant de la puissance calorifique ($\dot{Q}_1$ - $\dot{Q}_8$) des zones de chauffage ($H_1$ - $H_8$) respective située verticalement au-dessous des zones de couplage thermique ($Z_1$ - $Z_8$) de telle sorte que les zone de couplage thermique ($Z_3$, $Z_4$, $Z_5$, $Z_6$) de conductivité thermique élevée correspondent localement à des zones de chauffage ($H_3$, $H_4$, $H_5$, $H_6$) de puissance calorifique élevée ($\dot{Q}_3$, $\dot{Q}_4$, $\dot{Q}_5$, $\dot{Q}_6$) et des zones de couplage thermiques ($Z_1$, $Z_2$) de faible conductivité thermique correspondent localement à des zones de chauffage ($H_1$, $H_2$) de faible puissance calorifique ($\dot{Q}_1$ - $\dot{Q}_2$), **caractérisé en ce que** la fente horizontal (9) est raccordée à une entrée de gaz de purge (16) pour permettre à un gaz de purge de s'écouler à travers la fente horizontale (9) .

2. Dispositif selon la revendication 1, **caractérisé en ce que** les hauteurs de fente ($S_1$, $S_2$) dans la région d'une zone d'entrée de gaz adjacente à l'élément d'admission de gaz (4) et les hauteurs de fente ($S_7$, $S_8$) dans la région d'une zone de sortie de gaz éloignée de l'élément d'admission de gaz (4) sont plus grandes que les hauteurs de fente ($S_3$ - $S_6$) d'une zone de croissance qui est disposée entre une zone d'entrée de gaz et une zone de sortie de gaz et dans laquelle le au moins un substrat (5) est disposé.

3. Dispositif selon l'une des revendications précédentes, **caractérisé en ce que** la surface des éléments d'évacuation de chaleur (8), qui est tournée vers la plaque de plafond (3) et qui délimitent la fente horizontale (9), s'étend de manière étagée ou incurvée comme une paroi lisse.

4. Dispositif selon l'une des revendications précédentes, **caractérisé par** une construction à symétrie de centre de la chambre de traitement, l'élément d'admission de gaz (4) étant disposé au centre de symétrie autour duquel sont disposées la plaque de plafond (3) de forme circulaire et l'élément d'évacuation de chaleur (8) de forme circulaire, formé en particulier d'anneaux placés les uns à côté des autres.

5. Dispositif selon l'une des revendications précédentes, **caractérisé en ce que** l'élément d'admission de gaz (4) est raccordé à au moins un conduit d'amenée d'hydrure (13, 15) et à un conduit d'amenée de MO (14), l'au moins un conduit d'amenée d'hydrure (13, 15) débouchant dans une zone d'entrée (10, 12) qui lui est associée, et le conduit d'amenée de MO (14) débuchant dans une zone d'entrée (11) qui lui est associée, la zone d'entrée de MO (11) étant de préférence adjacente, verticalement des deux côtés, à une zone d'entrée (10, 12) destinée à l'hydrure.

6. Dispositif selon l'une des revendications précédentes, **caractérisé en ce que** la plaque de plafond (3) est en graphite ou en quartz et est notamment fabriquée d'une seule pièce.

7. Dispositif selon l'une des revendications précédentes, **caractérisé en ce que** la hauteur verticale de la chambre de traitement (1) diminue dans le sens d'écoulement du gaz de traitement, sortant de l'élément d'amission de gaz (14), en direction d'un élément de sortie de gaz (17).

8. Dispositif selon l'une des revendications précédentes, **caractérisé en ce que** le moyen de chauffage (7) est formé d'une pluralité de zones de chauffage ($H_1$ - $H_8$) entourant annulairement le centre (19) de la chambre de traitement (1).

9. Utilisation d'un dispositif selon l'une des revendications précédentes, **caractérisée en ce que** une croissant de couche est effectuée sur au moins un substrat dans le dispositif par introduction de gaz de traitement dans l'élément d'admission de gaz (4) et par décomposition thermique des gaz de traitement dans la chambre de traitement (1) en les composants formant la couche, les puissances calorifiques ($\dot{Q}_1$ - $\dot{Q}_8$) des zones de chauffage ($H_1$ - $H_8$) étant choisies de telle sorte que la différence maximale, en deux points quelconques, des températures mesurées au niveau de la plaque de plafond soit de 100 °C, de préférence de 50 °C.

10. Utilisation selon la revendication 9, **caractérisée en ce que** la température au niveau de la plaque de plafond (3) sur toute sa surface est supérieure à la température de formation d'adduit des gaz de traitement utilisés et est inférieure à la température à laquelle la croissance cristalline sur un substrat est cinétiquement limitée et est notamment, par exemple pour GaN, dans la gamme comprise entre 500 ° et 800 °C et pour GaAs ou InP entre 150 °C et 550 °C.

11. Procédé de dépôt d'au moins une couche notamment cristalline sur au moins un substrat (5) à l'aide d'un dispositif selon l'une des revendications 1 à 8, **caractérisé en ce que** la plaque de plafond (3) a, sur toute sa surface tournée vers la chambre de traitement (1), une température qui est supérieure à la température de formation d'adduit des gaz de traitement, mais inférieure à une température à laquelle la croissance cristalline sur un substrat est cinétiquement limitée.

Fig.1

Fig.2

Fig. 3

Fig. 4

Fig. 5

**EP 2 408 952 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4961399 A
- DE 10247921 A1
- DE 10043599 A1
- DE 102004009130 A1
- US 20040250773 A1
- US 20030005886 A1
- DE 102007009145
- JP 2008195995 A